# FASCICULE DE BREVET EUROPEEN

(11) **EP 1 614 134 B1**
(45) Date de publication et mention de la délivrance du brevet: **16.08.2006**
(21) Numéro de dépôt: 04742475.9
(22) Date de dépôt: 09.04.2004
(51) Int. Cl.: H01H 50/60, H01H 50/44, H01H 50/04, H01H 50/14, H01H 49/00

(54) **RELAIS ELECTROMAGNETIQUE**
ELEKTROMAGNETISCHES RELAIS
ELECTROMAGNETIC RELAY

(30) Priorité: 14.04.2003 FR 0304669
(43) Date de publication de la demande: 11.01.2006
(73) Titulaire: RADIALL, 93116 Rosny-Sous-Bois (FR)
(72) Inventeur: Janot, Fabrice, 38070 Saint Quentin Fallavier (FR); Becavin, Patrice, 38090 Villefontaine (FR); Gonin, Pascal, 38290 Frontonas (FR)
(74) Mandataire: Leszczynski, André
(86) Numéro de dépôt international: PCT/FR2004/000890
(87) Numéro de publication internationale: WO 2004/093113

(56) Documents cités:
- EP-A- 0 352 884
- DE-A- 19 834 215
- FR-A- 1 309 744
- PATENT ABSTRACTS OF JAPAN vol. 1995, no. 04, 31 mai 1995 (1995-05-31) -& JP 07 014489 A (MATSUSHITA ELECTRIC WORKS LTD), 17 janvier 1995 (1995-01-17)
- PATENT ABSTRACTS OF JAPAN vol. 1995, no. 11, 26 décembre 1995 (1995-12-26) -& JP 07 211212 A (MATSUSHITA ELECTRIC WORKS LTD), 11 août 1995 (1995-08-11)

## Description

La présente invention a pour objet un relais électromagnétique destiné notamment à être utilisé dans le domaine des hautes fréquences.

On connaît par le brevet US 4 839 619 un relais comportant un substrat, tel qu'une carte de circuit imprimé, sur lequel est monté un ensemble comportant un rotor et une armature magnétique portant une couche d'élastomère et une couche diélectrique. Cette dernière comporte des bandes conductrices aptes à commuter des pistes conductrices du substrat. Le rotor, outre qu'il peut être entraîné en rotation autour d'un axe perpendiculaire au plan du substrat, peut être déplacé axialement suivant cet axe. Du fait que le rotor doit pouvoir être entraîné alternativement en rotation et en translation, ce relais présente une structure relativement complexe, ce qui peut entraîner un coût de revient relativement important. Cette structure relativement complexe peut également rendre plus difficile la réalisation d'un relais compact, présentant un encombrement réduit.

On connaît également par le brevet US 6 081 176 un relais électromagnétique comportant un système à aimants, une base, un élément de contact mobile, des éléments de contact fixe et des éléments de contact terminaux. La base est formée par deux cartes de circuit imprimé ménageant entre elles un espace permettant de loger l'élément de contact mobile. Le système à aimants n'est pas monté sur la base.

Le document "JP 07 014 489 A" décrit un relais électromagnétique selon le préambule de la revendication 1.

L'invention vise notamment à proposer un relais électromagnétique qui est relativement compact, avec un encombrement réduit, et de structure relativement simple.

L'invention a pour objet un relais électromagnétique comportant :
- une base comprenant au moins une carte de circuit imprimé, laquelle comporte au moins deux pistes conductrices formant deux accès de commutation,
- au moins un élément de contact conducteur, mobile entre une position de fermeture dans laquelle il s'applique contre lesdites deux pistes conductrices afin d'établir une connexion électrique entre celles-ci et une position d'ouverture dans laquelle l'élément de contact est éloigné de l'une au moins desdites deux pistes,
- un actionneur monté sur la carte de circuit imprimé, comportant au moins un bobinage comprenant un enroulement de fils électriques,
l'actionneur étant notamment agencé pour pouvoir déplacer l'élément de contact uniquement suivant un mouvement dépourvu de composante de rotation autour d'un axe perpendiculaire au plan de la carte de circuit imprimé.

Grâce à l'invention, du fait que le mouvement de l'élément de contact peut être élémentaire, tel qu'un pivotement ou une translation, l'actionneur peut présenter une structure relativement simple.

La structure du relais peut être encore simplifiée du fait que la carte de circuit imprimé sert de support à l'actionneur.

Il est ainsi possible de réaliser un relais compact, avec un faible encombrement, et présentant un coût de revient réduit.

Le relais selon l'invention peut permettre de commuter une puissance pouvant être supérieure à 5 Watts et pouvant aller jusqu'à environ 200 Watts pour une fréquence de 1 GHz, notamment d'environ 80 Watts.

Dans un exemple de mise en oeuvre de l'invention; le relais comporte en outre un support d'élément de contact, ce support comportant au moins un bras flexible portant l'élément de contact.

Le support comporte avantageusement au moins une portion, notamment sous la forme d'une languette, sur laquelle agit un organe mobile de l'actionneur pour déplacer ledit bras flexible du support.

Dans ce cas, le support est indépendant de l'organe mobile, ce qui peut présenter les avantages suivants.

Tout d'abord on obtient une facilité de montage, de manipulation et de stockage des actionneurs car ceux-ci sont dépourvus d'élément de contact, lesquels peuvent être particulièrement fragiles et sensibles aux pollutions. De plus les actionneurs lesquels peuvent être constitués d'éléments standards, peuvent être pré-assemblés.

Ces actionneurs peuvent en outre être assemblés sur des cartes de circuit imprimé de type différent, et venir agir sur des supports d'éléments de contact de différentes formes.

L'invention permet également de fixer plusieurs actionneurs sur une même carte de circuit imprimé, avec des supports d'éléments de contact de formes différentes, et réaliser ainsi des systèmes de commutation complexes, notamment des matrices de commutation.

Par ailleurs, le réglage des forces de contact, de verrouillage, et des tensions de commutation du relais peut être effectué simplement par la modification de la distance entre l'actionneur et le support.

Le support peut comporter au moins une portion assujettie de manière rigide à une partie fixe du relais.

Ainsi, on évite des frottement entre le support et cette partie fixe du relais, même lorsque le bras flexible est actionné, ce qui permet de prévenir la formation de poussières ou de copeaux.

L'invention permet en outre un positionnement précis de l'élément de contact par rapport aux pistes conductrices et une répétabilité améliorée de ce positionnement.

N'étant pas fixé à l'organe mobile de l'actionneur, l'élément de contact n'est pas tributaire du jeu fonctionnel apparaissant au niveau de la liaison entre l'organe mobile et une partie fixe du relais ou de l'actionneur.

Dans le cas d'une liaison entre le support et l'organe mobile de l'actionneur, toute variation de position de l'organe mobile durant chaque commutation entraînerait une variation de la position de l'élément de contact par rapport aux pistes conductrices.

Une répétabilité améliorée du positionnement des éléments de contact garantit une excellente répétabilité des caractéristiques hyperfréquences, notamment en pertes d'insertion et rapport d'ondes stationnaires, lesquelles caractéristiques s'avèrent importantes pour les applications de mesure et instrumentation.

L'organe mobile précité peut comporter une palette apte à pivoter autour par exemple d'un axe parallèle au plan de la carte de circuit imprimé.

La palette peut être réalisée d'un seul tenant et/ou être sensiblement plane.

De préférence, le support est réalisé d'un seul tenant et est généralement flexible.

Le support peut être réalisé en un matériau conducteur et porter un bloc isolant agencé pour isoler l'élément de contact du support.

Ceci permet notamment d'éviter des problèmes de court-circuit et, lorsque le relais est utilisé dans le domaine des hautes fréquences, des perturbations d'impédance par effet capacitif.

Dans un exemple de mise en oeuvre de l'invention, l'élément de contact comporte une couche conductrice déposée sur une première face du bloc isolant, lequel est fixé au support par une deuxième face opposée à la première.

En variante, l'élément de contact est constitué par une lame conductrice et le bloc isolant est issu du surmoulage du support et de cette lame.

Dans un autre exemple de mise en oeuvre de l'invention, le support est réalisé en un matériau isolant.

L'élément de contact peut alors comporter une couche conductrice déposée sur une région du support.

De manière générale, l'invention permet de ne pas utiliser, pour relier l'élément de contact au support, de pièce intermédiaire isolante fixée dans un orifice du support et susceptible de générer des copeaux par frottement de la pièce sur le support.

Dans un exemple de mise en oeuvre de l'invention, le support porte une pluralité d'éléments de contact associés chacun à deux accès de commutation de la carte de circuit imprimé.

Dans un exemple de mise en oeuvre de l'invention, l'élément de contact n'est pas porté par un bras flexible mais par un organe mobile de l'actionneur.

Cet organe mobile peut comporter une tige apte à être déplacée axialement, perpendiculairement au plan de la carte de circuit imprimé, ou une palette apte à pivoter autour d'un axe parallèle au plan de la carte de circuit imprimé, par exemple.

L'élément de contact passe de la position d'ouverture à la position de fermeture ou inversement, sans glisser sur la carte de circuit imprimé.

La carte de circuit imprimé peut comporter au moins une piste conductrice d'alimentation électrique reliée électriquement audit au moins un bobinage électrique. Cette liaison peut être réalisée par un organe de raccord séparé du bobinage ou par une borne du bobinage.

L'organe de raccord peut être agencé pour être fixé, notamment par brasure, dans un orifice de la carte de circuit imprimé et comporter une broche avec une fente dans laquelle peut s'engager une borne du bobinage. Le bobinage peut être séparé de la carte de circuit imprimé.

Dans un exemple de mise en oeuvre de l'invention, la base comporte une pluralité de cartes de circuit imprimé, empilées et fixées entre elles, des pistes conductrices de ces cartes pouvant être reliées entre elles par des orifices métallisés réalisés dans l'épaisseur de l'une au moins de ces cartes.

L'empilage des cartes de circuit imprimé peut former une structure de type « stripline » permettant d'obtenir des performances satisfaisantes dans le domaine des hautes fréquences.

En disposant des pistes conductrices sur plusieurs niveaux de l'empilage, il est possible de réaliser des fonctions de commutation plus complexes.

Lorsque le relais est du type CMS (*Composants montés en surface),* ou SMT *(Surface Mounting Technology)* en anglais, l'une au moins des pistes conductrices peut être reliée à une bande conductrice s'étendant suivant l'épaisseur de la carte de circuit imprimé, cette bande pouvant être réalisée sur une tranche de la carte de circuit imprimé, étant notamment constituée par une surface métallisée dans un renfoncement de la tranche de la carte, ou être constituée par la paroi métallisée d'un orifice de la carte de circuit imprimé.

Ces bandes métallisées sont destinées à permettre une liaison par brasure entre les pistes conductrices de la carte du relais et celles du circuit ou de la carte destinée à recevoir le relais.

Cette brasure peut être particulièrement fiable puisqu'elle peut être effectuée entre deux cartes de circuit imprimé réalisées en un matériau de même nature et présentant des coefficients de dilatation thermique identiques.

En variante, l'une au moins des pistes conductrices est reliée à une embase permettant le raccordement d'un câble coaxial ou d'un connecteur coaxial.

La carte de circuit imprimé peut être réalisée à base de verre époxy ou de céramique.

Dans un exemple de mise en oeuvre de l'invention, le relais comporte un capot fixé, notamment par collage, sur la carte de circuit imprimé. La mise en place du capot peut être relativement aisée.

Le relais peut être du type SPDT (*Single Pole Double Throw*), DPDT *(Double Pole Double Throw*), DP3T *(Double Pole Triple Throw),* SPNT *(Simple Pole N Throw)* ou NPNT *(N Pole N Throw*).

L'actionneur peut être du type monostable ou bistable.

L'invention a encore pour objet un procédé de fabrication d'un relais électromagnétique tel que précité, la base comportant une pluralité de cartes de circuit imprimé, empilées et fixées entre elles, caractérisé par le fait que le procédé comporte les étapes suivantes :
- découper une pluralité de cartes de circuit imprimé,
- graver sur ces cartes des pistes conductrices,
- empiler ces cartes de circuit imprimé,
- soumettre à la cuisson cet empilement de cartes de manière à réaliser un frittage.

Pour la mise en oeuvre du procédé précité, on peut notamment utiliser 1a technique appelée « *Low Temperature Cofired Ceramics* ».

L'invention a encore pour objet un relais électromagnétique comportant :
- une base comportant au moins une carte de circuit imprimé, laquelle comprend au moins deux pistes conductrices formant deux accès de commutation,
- au moins un élément de contact conducteur, mobile entre une position de fermeture dans laquelle il s'applique contre les deux pistes conductrices afin d'établir une connexion électrique entre celles-ci et une position d'ouverture dans laquelle l'élément de contact est éloigné de l'une au moins desdites deux pistes,
- un actionneur monté sur la carte de circuit imprimé, comportant au moins un bobinage présentant un enroulement de fils électriques,
caractérisé par le fait que la carte de circuit imprimé comporte en outre au moins une piste conductrice d'alimentation électrique, séparée des deux pistes conductrices formant accès de commutation, et par le fait que le bobinage est relié à la piste d'alimentation électrique.

L'invention a encore pour objet un relais électromagnétique comportant :
- une base comportant une pluralité de cartes de circuit imprimé, empilées et fixées entre elles, au moins l'une des cartes de circuit imprimé comprend au moins deux pistes conductrices formant deux accès de commutation,
- au moins un élément de contact conducteur, mobile entre une position de fermeture dans laquelle il s'applique contre les deux pistes conductrices afin d'établir une connexion électrique entre celles-ci et une position d'ouverture dans laquelle l'élément de contact est éloigné de l'une au moins desdites deux pistes,
- un actionneur monté sur la base, comportant au moins un bobinage présentant un enroulement de fils électriques.

L'invention pourra être mieux comprise à la lecture de la description détaillée qui va suivre, d'exemples de mise en oeuvre non limitatifs, et à l'examen du dessin annexé, sur lequel :
- la figure 1 représente, schématiquement et partiellement, en vue éclatée, un relais électromagnétique conforme à l'invention,
- la figure 2 représente, schématiquement et partiellement, le relais de la figure 1, après assemblage de l'actionneur sur la carte de circuit imprimé,
- la figure 3 est une vue schématique et partielle de la carte et de certains éléments de l'actionneur du relais des figures 1 et 2,
- les figures 4 et 5 représentent, schématiquement et partiellement, en perspective, un support des éléments de contact conforme à deux variantes de mise en oeuvre de l' invention,
- la figure 6 est une vue analogue à la figure 3, représentant un relais conforme à une variante de mise en oeuvre de l'invention,
- la figure 7 représente schématiquement et partiellement, en coupe axiale, un relais conforme à un autre exemple de mise en oeuvre de l'invention,
- les figures 8 à 10 illustrent, schématiquement et partiellement, une base d'un relais conforme à un autre exemple de mise en oeuvre de l'invention, respectivement en vue de dessous, de côté et de dessus,
- les figures 11 à 14 représentent, schématiquement et partiellement, différentes dispositions d'accès de commutation d'un relais conforme à l'invention,
- la figure 15 représente, schématiquement et partiellement, un relais conforme à un autre exemple de mise en oeuvre de l'invention, et
- la figure 16 représente, schématiquement et partiellement, un support conforme à un autre exemple de mise en oeuvre de l'invention.

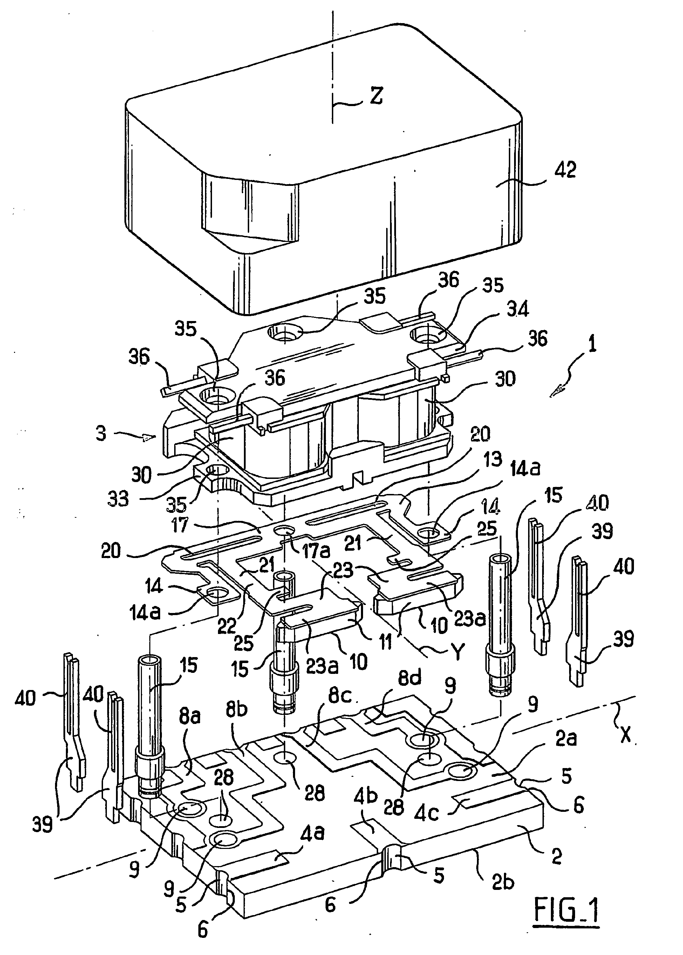

On a représenté sur la figure 1 un relais électromagnétique 1 conforme à l'invention, comportant une base 2 constituée par une carte de circuit imprimé réalisée à base de verre époxy ou de céramique, et un actionneur 3 apte à être monté sur la carte de circuit imprimé 2.

Cette dernière s'étend dans un plan défini par deux axes perpendiculaires X et Y.

La carte 2 comporte, dans l'exemple décrit, sur sa face supérieure 2a, trois pistes conductrices 4a, 4b et 4c, les deux pistes 4a et 4b formant une première paire d'accès de commutation et les pistes 4b et 4c formant une deuxième paire d'accès de commutation.

Ces pistes conductrices 4a-4c sont reliées chacune, à une extrémité, à une bande conductrice 5 formée par la métallisation d'un renfoncement 6 réalisé sur une tranche de la carte 2.

Les renfoncements 6 présentent, dans l'exemple décrit, une forme demi-cylindrique d'axe Z perpendiculaire au plan de la carte 2. En variante, ces renfoncements 6 peuvent présenter une forme en quart de cylindre. En variante encore, les bandes conductrices 5 peuvent être réalisées chacune sur la paroi d'un orifice de la carte 2. Ces bandes 5 peuvent encore être réalisées sur une tranche plane de la carte 2.

Les bandes conductrices 5 permettent d'établir des connexions par brasure entre les pistes conductrices 4a-4c et des pistes conductrices d'une autre carte de circuit imprimé destiné à recevoir le relais 1.

La face inférieure 2b de la carte 2 peut être métallisée permettant, lorsque cela est nécessaire, d'obtenir un blindage satisfaisant et une meilleure adaptation d'impédance dans le domaine des hautes fréquences.

La carte 2 comporte en outre quatre pistes conductrices 8a-8d d'alimentation électrique, reliées chacune à une extrémité à un orifice métallisé 9 et, à l'autre extrémité, à des bandes conductrices 5 telles que définies plus haut, permettant de relier ces pistes 8a-8d à une source d'alimentation électrique.

La commutation des pistes 4a et 4b, respectivement 4b et 4c, s'effectue à l'aide de deux éléments de contact conducteurs 10, mobiles entre une position de fermeture dans laquelle l'élément de contact 10 correspondant s'applique contre les deux pistes 4a et 4b, respectivement 4b et 4c, afin d'établir une connexion électrique entre celles-ci et une position d'ouverture dans laquelle l'élément de contact 10 est éloigné desdites deux pistes.

Chaque élément de contact 10 est constitué par une couche d'un matériau conducteur déposée sur une première face plane d'un bloc isolant 11, lequel est fixé par une face opposée à la première à un support conducteur généralement flexible 13.

Le support 13 peut être réalisé en cuivre béryllium ou tout autre métal ou alliage.

Ce dernier comporte deux portions latérales 14 d'axe Y pourvues chacune d'un orifice 14a destiné à s'engager sur une tige de maintien 15.

Ces portions latérales 14 se raccordent, perpendiculairement, à une partie centrale 17 d'axe X, comportant en son milieu un orifice 17a permettant d'engager cette partie 17 sur une tige 15.

Cette partie centrale 17 comporte de part et d'autre de l'orifice 17a deux fentes 20.

Le support 13 comporte en outre deux bras flexibles 21 se raccordant chacun à la partie centrale 17 par une portion sensiblement rectiligne 22 d'axe Y, prolongée par une portion d'extrémité 23.

Cette dernière présente une forme sensiblement en U d'axe X lorsqu'observée de dessus.

Chaque bras 21 comporte, reliée à la portion 22, une languette 25 d'axe X.

Comme on peut le voir sur la figure 1, le support 13 présente une symétrie axiale par rapport à l'axe Y.

Chaque bloc isolant 11 est fixé sur la branche 23a la plus extérieure du U.

Dans l'exemple décrit, le bloc isolant 11 et la couche conductrice 10 correspondante sont obtenus par découpage d'une carte de circuit imprimé comportant une piste conductrice.

Les tiges 15 sont destinées à être fixées à leur extrémité inférieure dans des orifices 28 réalisés dans la carte 2.

L'actionneur 3 comporte de manière conventionnelle deux bobinages 30 présentant chacun un enroulement de fils électriques autour d'un noyau, permettant d'actionner un organe mobile constitué, dans l'exemple décrit, par une palette 31 apparente sur la figuré 3.

Cette palette 31 est montée sur l'actionneur 3 de manière pivotante autour de l'axe Y, pouvant venir alternativement s'appliquer contre l'une des languettes 25 du support 13 afin de faire fléchir le bras 21 correspondant et provoquer le déplacement vers le bas de l'élément de contact 10 en vue de connecter les pistes 4a et 4b, ou 4b et 4c.

Dans un exemple non illustré, la palette 31 peut être remplacée par des organes mobiles déplaçables linéairement, parallèlement à l'axe Z, qui viennent s'appliquer chacune contre une languette 25 du support 13.

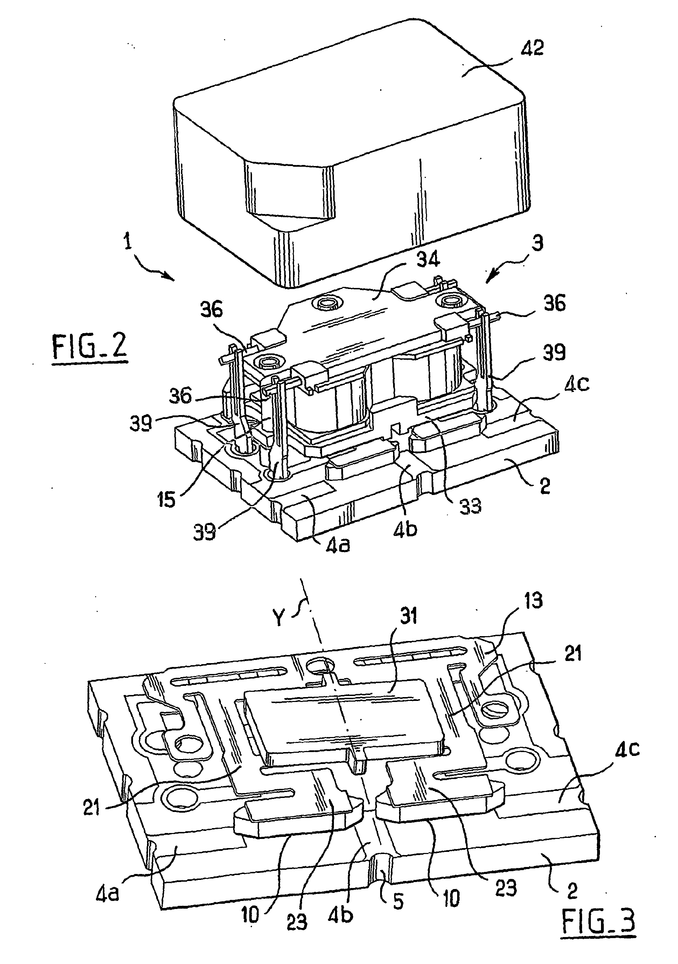

L'actionneur 3 comporte des parois inférieure 33 et supérieure 34 pourvues d'orifices 35 permettant de fixer l'actionneur 3 sur les tiges de maintien 15, comme illustré sur la figure 2.

Chaque bobinage 30 comporte, dans l'exemple considéré, deux bornes 36 faisant saillie vers l'extérieur.

Ces bornes 36 sont connectées électriquement chacune à une piste d'alimentation électrique 8a-8d par l'intermédiaire d'une broche 39.

Chaque broche 39 comporte une fente 40 dans laquelle vient s'engager une borne 36.

Chaque broche 39 est fixée, par brasure par exemple, à son extrémité inférieure dans un orifice métallisé 9 de la carte 2.

Ainsi, l'alimentation électrique de l'actionneur 3 s'effectue *via* les pistes conductrices 8a-8d, les broches 39 et les bornes 36.

Ceci permet notamment de rendre le relais 1 plus compact et de réduire le nombre de pièces constitutives de celui-ci.

Dans un exemple non illustré, les bornes 36 des bobinages 30 sont agencées pour être fixées directement dans les orifices 9 de la carte 2, sans l'aide de broches 39.

Le relais 1 comporte un capot 42 apte à être fixé par collage sur la carte 2.

Dans une variante, les tiges de maintien 15 sont réalisées d'un seul tenant avec l'une au moins des parois inférieure 33 et supérieure 34 de l'actionneur. D'une manière générale, l'actionneur 3 peut être fixé sur la carte 2 par tout moyen approprié.

On ne sort pas du cadre de la présente invention lorsque le support portant les éléments de contact est réalisé d'une autre manière.

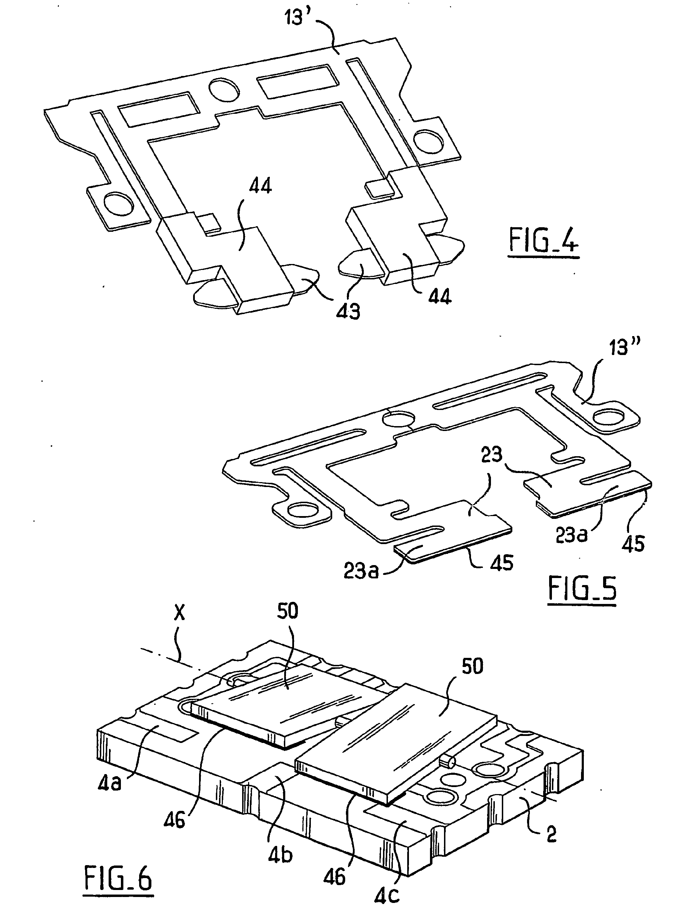

On a représenté sur la figure 4 un support 13' se différenciant du support 13 précédemment décrit, par le fait que chaque élément de contact est constitué par une lame conductrice 43 et que le bloc isolant 44 est issu de surmoulage du support 13' et des lames conductrices 43.

On a représenté sur la figure 5 un support 13" conforme à un autre exemple de mise en oeuvre de l'invention, lequel support 13" est réalisé en un matériau isolant, par exemple à base de céramique. L'élément de contact est constitué par une couche d'un matériau conducteur 45 déposée sur une face de la branche 23a de la portion d'extrémité 23.

Dans l'exemple décrit en référence à la figure 1, le support comporte des portions assujetties de manière rigide à une partie fixe du relais.

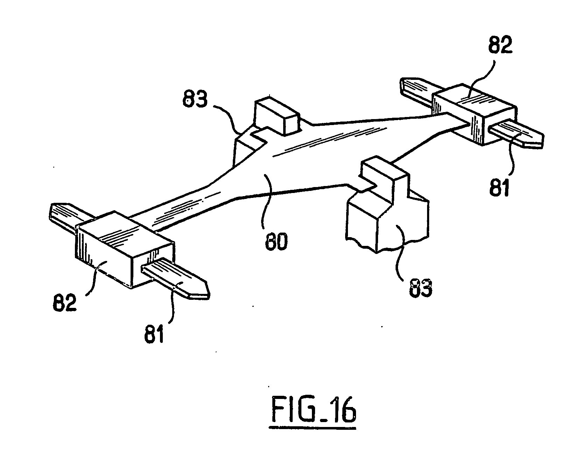

En variante, comme illustré sur la figure 16, le relais peut comporter un support 80, flexible et portant deux éléments de contact 81 par l'intermédiaire de deux blocs isolants 82, lequel support 80 est fixé de manière pivotante sur deux plots fixes 83.

Dans les exemples qui viennent d'être décrits, les éléments de contact sont réalisés sur un support généralement flexible entraîné en déplacement par un organe mobile de l'actionneur.

En variante, les éléments de contact peuvent être réalisés directement sur un organe mobile de l'actionneur.

On a représenté sur la figure 6 un exemple de mise en oeuvre de l'invention, dans lequel les éléments de contact sont constitués par une couche conductrice 46 déposée sur deux palettes 50 aptes à pivoter autour de l'axe X.

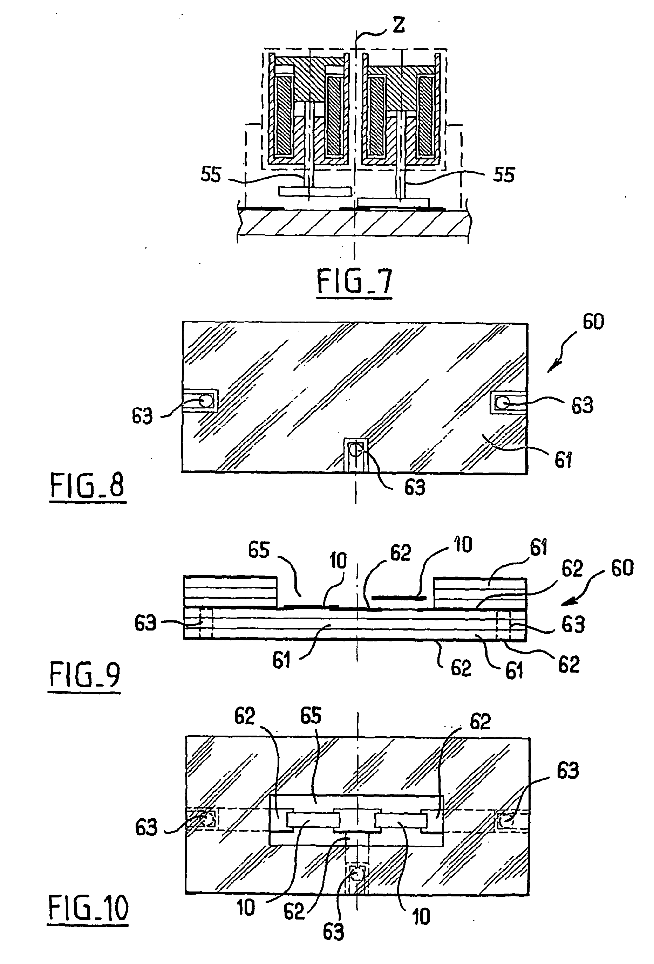

En variante encore, les éléments de contact peuvent être portés par des organes mobiles 55 de l'actionneur, comportant des poussoirs mobiles axialement suivant l'axe Z, comme illustré sur la figure 7.

La base du relais peut être constituée par une pluralité de cartes de circuit imprimé empilées et fixées entre elles.

Comme illustré sur les figures 8 à 10, cet empilement 60 de cartes de circuit imprimé 61 en céramique peut comporter des pistes conductrices 62 reliées entre elles par des orifices métallisés 63 réalisés dans l'épaisseur de certaines de ces cartes 61.

Les cartes 61 situées dans la partie supérieure de l'empilement 63 peuvent définir une cavité 65 dans le fond de laquelle débouchent les pistes conductrices 62 formant des accès de commutation.

L'empilement de cartes de circuit imprimé permet notamment d'obtenir des fonctions de commutation plus complexes.

Dans l'exemple considéré, cet empilement est réalisé par la technique « *Low Temperature Cofired Ceramics* ».

On a illustré sur les figures 11 à 14 différentes dispositions possibles des accès de commutation.

La figure 11 illustre une disposition à deux accès commutables par un unique élément de contact 10.

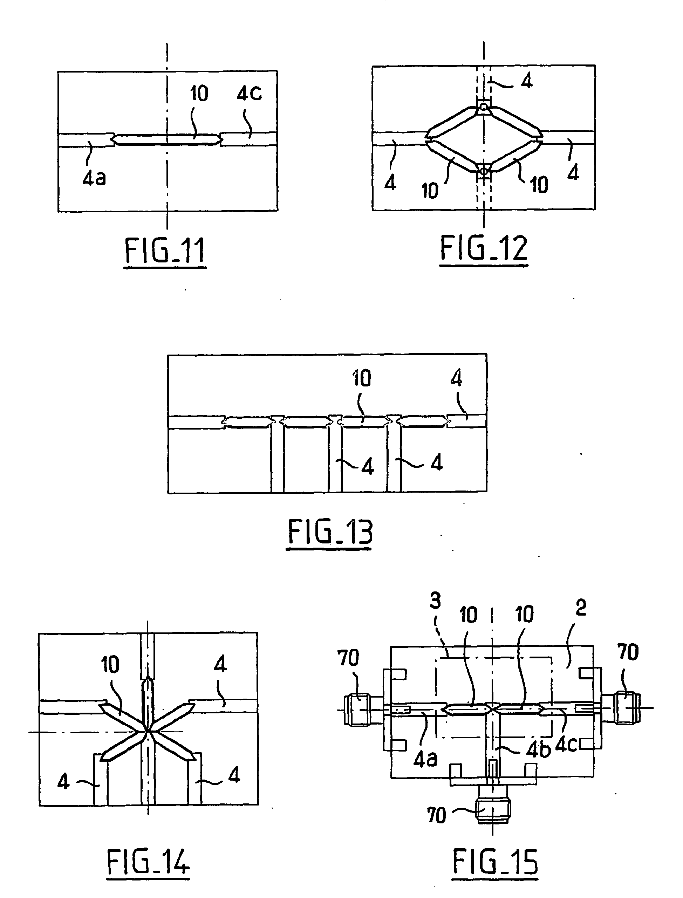

La figure 12 illustre une disposition à quatre accès 4 commutables par quatre éléments de contacts disposés en losange.

La figure 13 représente une disposition à cinq accès 4 commutables par quatre éléments de contact alignés.

La figure 14 représente une disposition à six accès 4 commutables par cinq éléments de contact disposés en étoile.

Bien entendu, l'invention n'est pas limitée aux exemples de mise en oeuvre qui viennent d'être décrits.

Dans les exemples qui sont décrits précédemment, le relais est de type CMS.

En variante, le relais peut comporter, comme illustré sur la figure 15, des embases 70 fixées chacune à une extrémité d'une piste conductrice 4a-4b.

Ces embases 70 permettent le raccordement, avec ou sans outil, de câbles coaxiaux ou de connecteurs coaxiaux.

Les embases décrites dans le brevet FR 2 786 613 de la société déposante peuvent être utilisées dans le relais selon la présente invention.

Ces embases permettent de raccorder un câble coaxial dénudé à une carte de circuit imprimé.

Les embases 70 peuvent être fixées sur la carte 2 ou être portées par une platine ou un boîtier. Cette platine ou ce boîtier peuvent permettre en outre d'assurer la protection et/ou la rigidité du relais et la fixation du relais sur un équipement. Ceux-ci peuvent encore servir de support à des bornes de connexion d'alimentation électrique des bobinages de l'actionneur.

## Revendications

1. Relais électromagnétique (1) comportant :
- une base comprenant au moins une carte de circuit imprimé (2), laquelle comporte au moins deux pistes conductrices (4a; 4b; 4c) formant deux accès de commutation,
- au moins un élément de contact conducteur (10), mobile entre une position de fermeture dans laquelle il s'applique contre lesdites deux pistes conductrices afin d'établir une connexion électrique entre celles-ci et une position d'ouverture dans laquelle l'élément de contact est éloigné de l'une au moins desdites deux pistes,
- un support (13) d'élément de contact (10), ce support comportant au moins un bras flexible (21) portant l'élément de contact (10).
- un actionneur (3) monté sur la carte de circuit imprimé, comportant au moins un bobinage (30) comprenant un enroulement de fils électriques,
**caractérisé par le fait que** le support (13) comporte au moins une portion, notamment sous la forme d'une languette (25), sur laquelle agit un organe mobile de l'actionneur pour déplacer ledit bras flexible (21) du support, ce support étant indépendant de l'organe mobile (31).

2. Relais selon la revendication 1, **caractérisé par le fait que** le support (13) est réalisé en un matériau conducteur et porte un bloc isolant (11) pour isoler l'élément de contact (10) du support (13).

3. Relais selon la revendication 2, **caractérisé par le fait que** l'élémént de contact (10) comporte une couche conductrice déposée sur une première face du bloc isolant (11), lequel est fixé au support (13) par une deuxième face opposée à la première.

4. Relais selon la revendication 2, **caractérisé par le fait que** l'élément de contact (10) est constitué par une lame conductrice (43) et **par le fait que** le bloc isolant (44) est issu du surmoulage du support et de cette lame.

5. Relais selon la revendication 1, **caractérisé par le fait que** le support (13) est réalisé en un matériau isolant.

6. Relais selon la revendication 5, **caractérisé par le fait que** l'élément de contact (10) comporte une couche conductrice (45) déposée sur une région du support (13).

7. Relais selon l'une quelconque des revendications précédentes, **caractérisé par le fait que** le support (13) comporte au moins une portion (14) assujettie de manière rigide à une partie fixe (15) du relais.

8. Relais selon l'une quelconque des revendications précédentes, **caractérisé par le fait que** le support (13) porte une pluralité d'éléments de contact (10) associés chacun à deux accès de commutation de la carte de circuit imprimé.

9. Relais selon l'une quelconque des revendications précédentes, **caractérisé par le fait que** l'organe mobile comporte une palette (31) apte à pivoter autour d'un axe (Y) parallèle au plan de la carte de circuit imprimé.

10. Relais selon l'une quelconque des revendications précédentes, **caractérisé par le fait que** le support (13) est réalisé d'un seul tenant.

11. Relais selon l'une quelconque des revendications précédentes, **caractérisé par le fait que** la carte de circuit imprimé (2) comporte au moins une piste conductrice (8a-8d) d'alimentation électrique reliée électriquement audit au moins un bobinage (30).

12. Relais selon la revendication 11, **caractérisé par le fait que** cette liaison est réalisée par un organe de raccord (39) fixé dans un orifice (9) de la carte de circuit imprimé.

13. Relais selon la revendication 12, **caractérisé par le fait que** l'organe de raccord (39) comporte une broche avec une fente (40) dans laquelle peut s'engager une borne (36) du bobinage (30).

14. Relais selon l'une quelconque des revendications précédentes, **caractérisé par le fait que** la base comporte une pluralité de cartes de circuit imprimé (61), empilées et fixées entre elles.

15. Relais selon la revendication 14, **caractérisé par le fait que** des pistes conductrices (62) de ces cartes sont reliées entre elles par des orifices métallisés (63) réalisés dans l'épaisseur de l'une au moins de ces cartes.

16. Relais selon l'une quelconque des revendications précédentes, **caractérisé par le fait que** l'une au moins des pistes conductrices (4a-4c ; 8a-8d) est reliée à une bande conductrice (5) s'étendant suivant l'épaisseur de la carte de circuit imprimé.

17. Relais selon la revendication 16, **caractérisé par le fait que** ladite bande conductrice (5) est réalisée sur une tranche de la carte de circuit imprimé (2), étant notamment constituée par une surface métallisée dans un renfoncement (6) de la tranche de la carte de circuit imprimé.

18. Relais selon la revendication 16, **caractérisé par le fait que** la bande conductrice (5) est constituée par la paroi métallisée d'un orifice de la carte de circuit imprimé.

19. Relais selon l'une quelconque des revendications 1 à 16, **caractérisé par le fait que** l'une au moins des pistes conductrices (4a-4c ; 8a-8d) est reliée à une embase (70) permettant le raccordement d'un câble coaxial ou d'un connecteur coaxial.

20. Relais selon l'une quelconque des revendications précédentes, **caractérisé par le fait que** la carte de circuit imprimé (2) est réalisée à base de verre époxy ou de céramique.

21. Relais selon l'une quelconque des revendications précédentes, **caractérisé par le fait qu'**il comporte un capot (40) fixé, notamment par collage, sur la carte de circuit imprimé.

22. Relais selon l'une quelconque des revendications précédentes, **caractérisé par le fait que** le bobinage (30) est séparé de la carte (2).

23. Procédé de fabrication d'un relais électromagnétique tel que défini dans l'une quelconque des revendications précédentes, la base comportant une pluralité de cartes de circuit imprimé, empilées et fixées entre elles, **caractérisé par le fait qu'**il comporte les étapes suivantes :
- découper une pluralité de cartes de circuit imprimé,
- graver sur ces cartes des pistes conductrices,
- empiler ces cartes de circuit imprimé,
- soumettre à la cuisson cet empilement de cartes.

## Claims

1. An electromagnetic relay (1) comprising:
· a base comprising at least one printed circuit card (2), which card has at least two conductor tracks (4a; 4b; 4c) forming respective switch accesses;
· at least one conductive contact element (10) movable between a closed position in which it presses against said two conductor tracks in order to establish an electrical connection between them, and an open position in which the contact element is spaced apart from at least one of said two tracks;
· a contact element support (13), the support comprising at least one flexible arm (21) carrying the contact element (10); and
· an actuator (3) mounted on the printed circuit card, and comprising at least one coil (30) constituted by a winding of electric wires;
the relay being **characterized by** the fact that the support (13) includes at least one portion, in particular a portion in the form of a tongue (25), on which a moving member of the actuator acts in order to move said flexible arm (21) of the support, said support being independent of the moving member (31).

2. A relay according to claim 1, **characterized by** the fact that the support (13) is made of a conductive material and carries an insulating block (11) to insulate the contact element (10) from the support (13).

3. A relay according to claim 2, **characterized by** the fact that the contact element (10) comprises a conductive layer deposited on a first face of the insulating block (11), which block is secured to the support (13) via a second face that is opposite from the first face.

4. A relay according to claim 2, **characterized by** the fact that the contact element (10) is constituted by a conductive blade (43) and by the fact that the insulating block (44) is obtained by overmolding on the support and the blade.

5. A relay according to claim 1, **characterized by** the fact that the support (13) is made of an insulating material.

6. A relay according to claim 5, **characterized by** the fact that the contact element (10) comprises a conductive layer (45) deposited on a region of the support (13).

7. A relay according to any preceding claim, **characterized by** the fact that the support (13) includes at least one portion (14) that is rigidly secured to a stationary portion (15) of the relay.

8. A relay according to any preceding claim, **characterized by** the fact that the support (13) carries a plurality of contact elements (10), each associated with two switch accesses of the printed circuit card.

9. A relay according to any preceding claim, **characterized by** the fact that the moving member comprises an armature (31) suitable for pivoting about an axis (Y) parallel to the plane of the printed circuit card.

10. A relay according to any preceding claim, **characterized by** the fact that the support (13) is made as a single piece.

11. A relay according to any preceding claim, **characterized by** the fact that the printed circuit card (2) has at least one electrical power supply conductor track (8a-8d) electrically connected to said at least one coil (30).

12. A relay according to claim 11, **characterized by** the fact that said connection is implemented via a connection member (39) fastened in a hole (9) in the printed circuit card.

13. A relay according to claim 12, **characterized by** the fact that the connection member (39) comprises a pin with a slot (40) in which a terminal (36) of the coil (30) can engage.

14. A relay according to any preceding claim, **characterized by** the fact that the base comprises a plurality of printed circuit cards (61) that are stacked on one another and fastened together.

15. A relay according to claim 14, **characterized by** the fact that the conductor tracks (62) of the card are interconnected by plated-through holes (63) made through the thickness of at least one of the cards.

16. A relay according to any preceding claim, **characterized by** the fact that at least one of the conductor tracks (4a-4c; 8a-8d) is connected to a conductive strip (5) extending across the thickness of the printed circuit card.

17. A relay according to claim 16, **characterized by** the fact that said conductive strip (5) is made on an edge face of the printed circuit card (2), being constituted in particular by a metal-plated surface in a setback (6) in the edge face of the printed circuit card.

18. A relay according to claim 16, **characterized by** the fact that the conductive strip (5) is constituted by the metal-plated wall of a hole in the printed circuit card.

19. A relay according to any one of claims 1 to 16, **characterized by** the fact that at least one of the conductor tracks (4a-4c; 8a-8d) is connected to a socket (70) enabling a coaxial cable or a coaxial connector to be connected thereto.

20. A relay according to any preceding claim, **characterized by** the fact that the printed circuit card (2) is made on the basis of glass epoxy or of ceramic.

21. A relay according to any preceding claim, **characterized by** the fact that it includes a cover (40) secured to the printed circuit card, in particular by adhesive.

22. A relay according to any preceding claim, **characterized by** the fact that the coil (30) is separate from the card (2).

23. A method of manufacturing an electromagnetic relay as defined in any preceding claim, the base comprising a plurality of printed circuit cards that are stacked on one another and fastened together, the method being **characterized by** the fact that it comprises the following steps:
· cutting out a plurality of printed circuit cards;
· etching conductor tracks on the cards;
· stacking the printed circuit cards; and
· firing the stack of cards.

## Patentansprüche

1. Elektromagnetisches Relais (1) mit:
- einem Sockel, der wenigstens eine gedruckte Schaltungskarte (2) aufweist, die wenigstens zwei leitende Bahnen (4a; 4b; 4c) aufweist, die zwei Schaltzugänge bilden,
- wenigstens einem leitenden Kontaktelement (10), das beweglich ist zwischen einer Schließstellung, in der es an den beiden leitenden Bahnen anliegt, um eine elektrische Verbindung zwischen diesen herzustellen, und einer Öffnungsstellung, in der das Kontaktelement von wenigstens einer der genannten beiden Bahnen abgerückt ist,
- einem Tragelement (13) für den Kontakt (10), wobei dieses Tragelement wenigstens einen flexiblen Arm (21) aufweist, der das Kontaktelement (10) trägt,
- einem auf der gedruckten Schaltungskarte montierten Betätigungsglied (3); das wenigstens eine Spule (30) aufweist, die eine Wicklung aus leitenden Drähten enthält,
**dadurch gekennzeichnet, daß** das Tragelement (13) wenigstens einen Teil insbesondere in der Form einer Zunge (25) aufweist, auf den ein bewegliches Organ des Betätigungsgliedes wirkt, um den genannten flexiblen Arm (21) des Trägers zu verstellen, wobei dieser Träger unabhängig von dem beweglichen Organ (31) ist.

2. Relais nach Anspruch 1, **dadurch gekennzeichnet, daß** der Träger (13) aus einem leitenden Material hergestellt ist und einen isolierenden Block (11) zum Isolieren des Kontaktelements (10) vom Träger (13) aufweist.

3. Relais nach Anspruch 2, **dadurch gekennzeichnet, daß** das Kontaktelement (10) eine leitende Schicht aufweist, die auf einer ersten Oberfläche des isolierenden Blockes (11) angeordnet ist, der mit einer der ersten Oberfläche entgegengesetzten zweiten Oberfläche an dem Träger (13) befestigt ist.

4. Relais nach Anspruch 2, **dadurch gekennzeichnet, daß** das Kontaktelement (10) durch ein leitendes Blatt (43) gebildet wird und **dadurch**, daß der isolierende Block (44) durch Anformen an den Träger und dieses Blatt gebildet ist.

5. Relais nach Anspruch 1, **dadurch gekennzeichnet, daß** der Träger (13) aus einem isolierenden Material hergestellt ist.

6. Relais nach Anspruch 5, **dadurch gekennzeichnet, daß** das Kontaktelement (10) eine leitende Schicht (45) aufweist, die auf einem Bereich des Trägers (13) angeordnet ist.

7. Relais nach einem der vorstehenden Ansprüche, **dadurch gekennzeichnet, daß** der Träger (13) wenigstens einen Teil (14) aufweist, der starr an einem festen Teil (15) des Relais befestigt ist.

8. Relais nach einem der vorstehenden Ansprüche, **dadurch gekennzeichnet, daß** der Träger (13) mehrere Kontaktelemente (10) aufweist, die jeweils zwei Schaltzugängen der gedruckten Schaltungskarte zugeordnet sind.

9. Relais nach einem der vorstehenden Ansprüche, **dadurch gekennzeichnet, daß** das bewegliche Organ eine Platte (31) aufweist, die um eine zur Ebene der gedruckten Schaltungskarte parallele Achse (Y) schwenkbar ist.

10. Relais nach einem der vorstehenden Ansprüche, **dadurch gekennzeichnet, daß** der Träger (13) in einem Stück ausgebildet ist.

11. Relais nach einem der vorstehenden Ansprüche, **dadurch gekennzeichnet, daß** die gedruckte Schaltungskarte (2) wenigstens eine leitende Bahn (8a-8d) zur elektrischen Versorgung aufweist, die elektrisch mit der genannten wenigstens einen Spule (30) verbunden ist.

12. Relais nach Anspruch 11, **dadurch gekennzeichnet, daß** diese Verbindung durch ein Anschlußorgan (39) gebildet wird, das in einer Öffnung (9) der gedruckten Schaltungskarte befestigt ist.

13. Relais nach Anspruch 12, **dadurch gekennzeichnet, daß** das Anschlußorgan (39) einen Stift mit einem Schlitz (40) aufweist, in den eine Klemme (36) der Spule (30) eingreifen kann.

14. Relais nach einem der vorstehenden Ansprüche, **dadurch gekennzeichnet, daß** der Sockel mehrere gedruckte Schaltungskarten (61) aufweist, die aufeinandergestapelt und aneinander befestigt sind.

15. Relais nach Anspruch 14, **dadurch gekennzeichnet, daß** die leitenden Bahnen (62) der Karten miteinander durch metallisierte Öffnungen (63) verbunden sind, die in der Dicke wenigstens einer der Karten ausgebildet sind.

16. Relais nach einem der vorstehenden Ansprüche, **dadurch gekennzeichnet, daß** wenigstens eine der leitenden Bahnen (4a-4c; 8a-8d) mit einem leitenden Band (5) verbunden ist, das sich in Richtung der Dicke der gedruckten Schaltungskarte erstreckt.

17. Relais nach Anspruch 16, **dadurch gekennzeichnet, daß** das genannte leitende Band (5) auf einer Randfläche der gedruckten Schaltungskarte (2) gebildet ist und insbesondere durch eine metallisierte Oberfläche in einer Vertiefung (6) der Randfläche der gedruckten Schaltungskarte gebildet ist.

18. Relais nach Anspruch 16, **dadurch gekennzeichnet, daß** das leitende Band (5) durch eine metallisierte Wand einer Öffnung der gedruckten Schaltungskarte gebildet ist.

19. Relais nach einem der Ansprüche 1 bis 16, **dadurch gekennzeichnet, daß** wenigstens eine der leitenden Bahnen (4a-4c; 8a-8d) mit einem Steckverbinder (70) verbunden ist, der den Anschluß eines Koaxialkabels oder eines Koaxialverbinders erlaubt.

20. Relais nach einem der vorstehenden Ansprüche, **dadurch gekennzeichnet, daß** die gedruckte Schaltungskarte (2) aus Epoxiglas oder Keramik hergestellt ist.

21. Relais nach einem der vorstehenden Ansprüche, **dadurch gekennzeichnet, daß** sie eine Haube (40) aufweist, die insbesondere durch Klebung an der gedruckten Schaltungskarte befestigt ist.

22. Relais nach einem der vorstehenden Ansprüche, **dadurch gekennzeichnet, daß** die Spule (30) von der Karte (2) getrennt ist.

23. Verfahren zur Herstellung eines elektromagnetischen Relais nach einem der vorstehenden Ansprüche, bei dem der Sockel mehrere aufeinandergestapelte und aneinander befestigte gedruckte Schaltungskarten aufweist, **dadurch gekennzeichnet, daß** es die folgenden Schritte umfaßt:
- Ausschneiden mehrerer gedruckter Schaltungskarten,
- Aufprägen von leitenden Bahnen auf diese Karten,
- Stapeln der gedruckten Schaltungskarten,
- Brennen dieses Stapels von Karten.
